# EUROPEAN PATENT APPLICATION

(11) **EP 1 246 031 A2**
(43) Date of publication of application: **02.10.2002**
(21) Application number: 02006943.1
(22) Date of filing: 26.03.2002
(51) Int. Cl.: G03H 1/04, G11C 13/04

(54) **Hologram recording medium, hologram recording-reproducing method, and hologram recording-reproducing apparatus**

(30) Priority: 30.03.2001 JP 2001101890
(71) Applicant: Pioneer Corporation, Meguro-ku, Tokyo (JP)
(72) Inventor: Tanaka, Satoru, Corporate R & D Laboratory, Tsurugashima-shi, Saitama 350-2288 (JP); Kouno, Tomomitsu, Corporate R & D Laboratory, Tsurugashima-shi, Saitama 350-2288 (JP); Itoh, Yoshihisa, Corporate R & D Laboratory, Tsurugashima-shi, Saitama 350-2288 (JP); Matsushita, Hajima, Corporate R & D Laboratory, Tsurugashima-shi, Saitama 350-2288 (JP)
(74) Representative: Lindner, Manfred Klaus, Dipl.-Phys.

(57) **Abstract**

A hologram recording medium can record an interference pattern to a volume holographic memory at high density. Therefore, the hologram recording medium is made of a photo refractive crystal of a uniaxial crystal having a shape of parallel flat plates, and has a plurality of areas of a refractive index grating corresponding to one portion of a three-dimensional light interference pattern of a coherent signal light beam and coherent reference light of a first wavelength modulated in accordance with information data, wherein the areas of the refractive index grating respectively have a spatially independent columnar shape and are juxtaposed in parallel with each other, and lattice vectors of the refractive index grating in the adjacent areas of the refractive index grating exist in directions different from each other.

## Description

### BACKGROUND OF THE INVENTION

### 1. Field of the Invention

The present invention relates to a hologram recording medium made of a photo refractive material, a so-called holographic memory, and also relates to a recording and reproducing method using a hologram and an optical information recording and reproducing apparatus utilizing the holographic memory.

### 2. Description of Related Art

A volume holographic recording system is known as a digital information recording system utilizing the principle of the hologram. This system is characterized in that an information signal is recorded in a recording medium as a change in refractive index. A photo refractive material such as a lithium niobate monocrystal is used in the recording medium.

A recording and reproducing method using a Fourier transformation is one of conventional implementations of the hologram recording and reproduction.

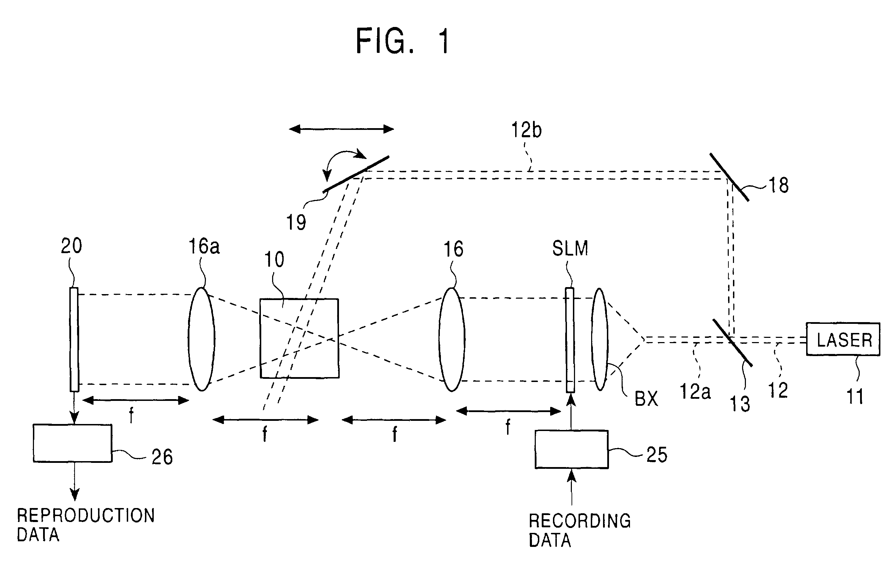

As shown in Fig. 1, in a conventional 4f-system hologram recording and reproducing apparatus, a laser beam 12 emitted from a laser beam source 11 is divided into signal light beam 12a and recording reference light beam 12b in a beam splitter 13. The diameter of the signal light beam 12a is enlarged by a beam expander BX, and is irradiated as parallel light to a spatial light modulator SLM such as a panel of a TFT liquid crystal display (LCD) of a transmission type. The spatial light modulator SLM receives recording data converted to a signal by an encoder as an electric signal, and forms a light and dark dot pattern on a plane. When the signal light beam 12a is transmitted through the spatial light modulator SLM, the signal light beam 12a is optically modulated and includes a data signal component. The signal light beam 12a including the dot pattern signal component is transmitted through a Fourier transformation lens 16 separated by its focal length f from the spatial light modulator SLM so that the dot pattern signal component is Fourier-transformed and is converged into a recording medium 10. At the same time, the recording reference light beam 12b divided in the beam splitter 13 is guided into the recording medium 10 by mirrors 18, 19, and crosses an optical path of the signal light beam 12a within the recording medium 10 so that a light interference pattern is formed. The entire light interference pattern is recorded as a change in refractive index (refractive index grating).

Thus, diffracted light from data of an image irradiated by coherent parallel light is focused and formed as an image by the Fourier transformation lens, and is transformed to a distribution on a focal plane of the Fourier transformation lens, i.e., on a Fourier plane. The distribution as a result of the Fourier transformation interferes with the coherent reference light, and its interference fringe is recorded to the recording medium in the vicinity of a focal point. After the recording operation on a first page is terminated, a rotating mirror is rotated by a predetermined amount and its position is displaced in parallel by a predetermined amount so that an incident angle of the recording reference light beam 12b with respect to the recording medium 10 is changed. The recording operation on a second page is then performed in the same procedure. Thus, an angle multiplex record is made by performing the sequential recording operation.

On the other hand, a dot pattern image is reproduced by performing a reverse Fourier transformation in the reproduction time. In reproduction of information, as shown in Fig. 1, for example the optical path of the signal light beam 12a is interrupted by the spatial light modulator SLM, and only the recording reference light beam 12b is irradiated to the recording medium 10. In reproduction, a position and an angle of the mirror are changed and controlled in combination with the rotation and the linear movement of the mirror so as to provide the same incident angle as the recording reference light at the recording time of a reproduced page. Reproducing light reproducing the recorded light interference pattern appears on an opposite side of the recording medium 10 irradiated by the recording reference light beam 12b. When this reproduction light is guided to a reverse Fourier transformation lens 16a and the reverse Fourier transformation is performed, the dot pattern signal can be reproduced. Further, after this dot pattern signal is received by a photo detector 20 such as a charge coupled device CCD in a focal length position and is reconverted to an electric digital data signal and is then sent to a decoder, the original data are reproduced.

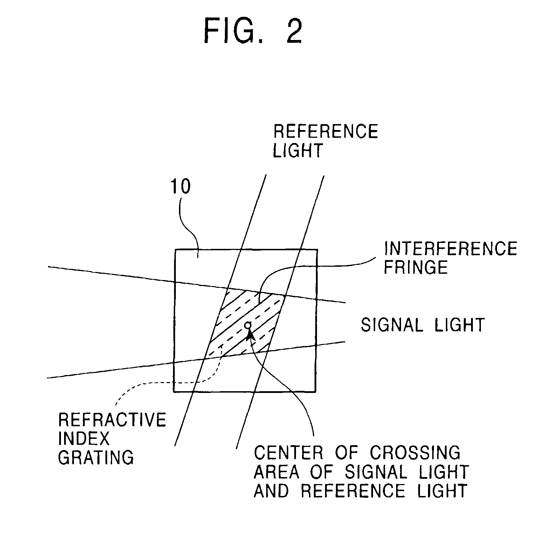

Thus, as shown in Fig. 2, the multiple record was conventionally made within the volume of about several mm in square using angle multiplex and wavelength multiplex to record information at high density within a certain volume within the recording medium. Therefore, coherent lengths of the signal light and the reference light are set to be long and wide to secure an angle selecting property and a wavelength selecting property. This leads to the reduction in intensity per light unit used in the recording, and the recording medium of high sensitivity has been required. Further, since the multiplex record is required to realize a high density recording, a recording medium having a large erasing time constant and able to be easily multiplexed has been required. The recording medium having a large erasing time constant is generally low in recording sensitivity, and resulted in a limited recording speed as a whole system.

Furthermore, two lenses constituted by the Fourier transformation lens and the reverse Fourier transformation lens of high performance are required in the conventional device. Furthermore, it is necessary to arrange a paging control mechanism of high accuracy to control the reference light in the recording and reproduction. A problem was that the provision of such a mechanism is disadvantageous for making a compact system.

Furthermore, in the case of conventional arrangements the multiplex record is performed in one portion of the recording medium. The changes in refractive index of the recording medium due to the multiplex recording are added and a wave front of the reference light after the medium transmission is gradually changed. Therefore, the number of multiplexing is limited when adopting the arrangement that the reference light is reflected so that it is used as reproduction reference light. Furthermore, it has been necessary to arrange a light shielding means for the reflected light so as to avoid accumulation of influences due to the formation of a diffraction grating in a direction of a reduced recording sensitivity at multiplex recording.

### OBJECT AND SUMMARY OF THE INVENTION

Therefore, an object of the present invention is to provide a hologram recording medium, a hologram recording-reproducing method and a hologram recording and reproducing apparatus capable of performing a high density recording and at the same time able to be made compact.

According to one aspect of the present invention, a hologram recording medium is made of a photo refractive crystal of a uniaxial crystal having a shape of parallel flat plates, and has a plurality of areas of a refractive index grating corresponding to one portion of a three-dimensional light interference pattern of a coherent signal light beam and coherent reference light of a first wavelength modulated in accordance with information data, wherein the areas of the refractive index grating respectively have a spatially independent columnar shape and are juxtaposed in parallel with each other, and lattice vectors of the refractive index grating in the adjacent areas of the refractive index grating exist in directions different from each other.

In the hologram recording medium of the present invention, the photo refractive crystal may be a crystal increased in recording sensitivity at the first wavelength when a gate light beam of a second wavelength is simultaneously irradiated in addition to the reference light and the signal light of the first wavelength.

In the hologram recording medium of the present invention, the photo refractive crystal may be a crystal whose recording sensitivity at the first wavelength increases when a gate light beam of a second wavelength is simultaneously irradiated in addition to the reference light and the signal light of the first wavelength.

In the hologram recording medium of the present invention, the photo refractive crystal may be an optical crystal axis approximately parallel or perpendicular to a main face of the recording medium.

In the hologram recording medium of the present invention, information data of one screen may be stored for each area of the refractive index grating.

In the hologram recording medium of the present invention, each of the areas of the refractive index grating may have a columnar shape extended approximately perpendicularly to the main face of the hologram recording medium.

In the hologram recording medium of the present invetion, each of the areas of the refractive index grating of the columnar shape approximately may have a cylindrical shape.

In the hologram recording medium of the present invention, a maximum inside diameter of the areas of the refractive index grating may be made smaller than the distance between peaks of zeroth-order and primary diffracted lights of a light intensity distribution of the signal light beam.

According to another aspect of the present invention, a hologram recording method is adapted for forming a plurality of areas of a refractive index grating corresponding to one portion of a three-dimensional light interference pattern of a coherent signal light beam and coherent reference light of a first wavelength modulated in accordance with information data within a recording medium made of a photo refractive crystal of a uniaxial crystal having a shape of parallel flat plates,
wherein the signal light beam and the recording reference light beam cross each other within the recording medium, and a gate light beam having a second wavelength for revealing recording sensitivity of the recording medium is simultaneously irradiated to the recording medium so as to pass through a portion of the recording medium for crossing the signal light beam and the recording reference light beam and demarcate a volume smaller than that of this crossing portion, and
the signal light beam is irradiated to the gate light beam from a different direction such that lattice vectors of the refractive index grating in adjacent areas of the refractive index grating exist in directions different from each other for each area of the refractive index grating.

In the hologram recording method of the present invention the gate light beam may be converged and the recording medium may be arranged in a waist of this gate light beam and its vicinity, and the areas of the refractive index grating may be formed in a columnar shape and are juxtaposed in parallel with each other.

In the hologram recording method of the present invention, the recording medium may have an optical crystal axis approximately parallel or perpendicular to a main face of the recording medium.

In the hologram recording method of the present invention the recording reference light beam and the gate light beam may be irradiated coaxially.

In the hologram recording method of the present invention the recording reference light beam may be converged.

In the hologram recording method of the present invention the recording reference light beam and the gate light beam may be approximately perpendicularly irradiated to a main face of the recording medium, and the areas of the refractive index grating of a columnar shape may be approximately perpendicularly extended to the main face of the recording medium.

In the hologram recording method of the present invention, the gate light beam and the signal light beam may be respectively irradiated such that a cross sectional area of the gate light beam on the surface of the recording medium is smaller than that of the signal light beam.

In the hologram recording method of the present invention, a maximum inside diameter of the areas of the refractive index grating may be made smaller than the distance between peaks of zeroth-order and primary diffracted lights of a light intensity distribution of the signal light beam.

According to a further aspect of the present invention, a hologram reproducing method is apapted for reproducing information data from a hologram recording medium in which the hologram recording medium is made of a photo refractive crystal of a uniaxial crystal having a shape of parallel flat plates, and has a plurality of areas of a refractive index grating respectively corresponding to one portion of a three-dimensional light interference pattern of a coherent signal light beam and coherent reference light modulated in accordance with the information data, and respectively having a spatially independent columnar shape, and juxtaposed in parallel with each other, and lattice vectors of the refractive index grating in the respective adjacent areas of the refractive index grating exist in directions different from each other, wherein the coherent reference light is incident to each of the areas of the refractive index grating of the hologram recording medium at a predetermined incident angle, and an image is formed in a spatially independent different direction from at least the adjacent areas of the refractive index grating.

In the hologram reproducing method of the present invention, the position of a detecting part for receiving the image formed spatially independently in the different direction from the adjacent areas of the refractive index grating may be switched when the reference light beam is incident to each of the areas of the refractive index grating at the predetermined incident angle.

According to a still further aspect of the present invention, a hologram recording and reproducing apparatus is adapted for forming a plurality of areas of a refractive index grating corresponding to one portion of a three-dimensional light interference pattern of a coherent signal light beam and coherent reference light of a first wavelength modulated in accordance with information data within a recording medium made of a photo refractive crystal of a uniaxial crystal having a shape of parallel flat plates,
the hologram recording and reproducing apparatus comprising:
a supporting part for detachably holding the recording medium made of the photo refractive crystal having the shape of parallel flat plates;
a reference light part for making a coherent recording reference light beam of the first wavelength approximately perpendicularly incident to a main face of the recording medium;
a signal light part for making the coherent signal light beam of the first wavelength modulated in accordance with the information data of one screen incident to the recording medium, and making the coherent signal light beam cross the recording reference light beam within the recording medium, and generating a light interference pattern of the signal light beam and the recording reference light beam;
a gate light part for making a gate light beam of a second wavelength for revealing recording sensitivity of the recording medium approximately perpendicularly incident to the main face of the recording medium together with the recording reference light beam, and forming the refractive index grating of one portion of the light interference pattern which passes through a portion of the recording medium for crossing the signal light beam and the recording reference light beam and demarcates a volume smaller than that of this crossing portion;
a switching part for irradiating the signal light beam to the gate light beam in a portion of the recording medium from a different direction such that lattice vectors of the refractive index grating in adjacent areas of the refractive index grating exist in directions different from each other for each area of the refractive index grating;
a phase conjugate wave generating part for generating a phase conjugate wave with respect to the signal light beam by irradiating a reproducing reference light beam coaxial with respect to the recording reference light beam and propagated in an opposite direction to the refractive index grating of the recording medium;
a separating part for separating the phase conjugate wave from an optical path of the signal light beam; and
a detecting part for detecting the information data formed as an image by the phase conjugate wave.

In the hologram recording and reproducing apparatus of the present invention, the apparatus may further comprise a part for switching between positions of the detecting part for receiving imaged formed spatially independently in different directions from the adjacent areas of the refractive index grating when the reference light beam is incident to each of the areas of the refractive index grating at a predetermined incident angle.

In the hologram recording and reproducing apparatus of the present invention, the detecting part may have a plurality of photo detector arrays, and the reproduction is performed by switching between a plurality of convergent lenses having different incident directions to the recording medium.

In the hologram recording and reproducing apparatus of the present invention, the signal light part may have a plurality of optical modulators, and the recording may be performed by switching between a plurality of convergent lenses having different incident directions to the recording medium.

In the hologram recording and reproducing apparatus of the present invention the apparatus may further comprise a part for converging the gate light beam and the recording medium is arranged in a waist of the gate light beam and its vicinity, and the areas of the refractive index grating may be formed in a columnar shape and are juxtaposed in parallel with each other.

In the hologram recording and reproducing apparatus of the present invention, the apparatus may further comprise a part for coaxially irradiating the recording reference light beam and the gate light beam.

In the hologram recording and reproducing apparatus of the present invention the apparatus may further comprise a part for converging the recording reference light beam.

In the hologram recording and reproducing apparatus of the present invention, the recording reference light beam and the gate light beam may be irradiated approximately perpendicularly to the main face of the recording medium, and the areas of the refractive index grating of a columnar shape may be extended approximately perpendicularly to the main face of the recording medium.

In the hologram recording and reproducing apparatus of the present invention the gate light beam and the signal light beam may be respectively irradiated such that a cross sectional area of the gate light beam on the surface of the recording medium is smaller than that of the signal light beam.

In the hologram recording and reproducing apparatus of the present invention a maximum inside diameter of the areas of the refractive index grating may be made smaller than the distance between peaks of zeroth-order and primary diffracted lights of a light intensity distribution of the signal light beam.

### BRIEF DESCRIPTION OF THE DRAWINGS

Fig. 1 is a schematic constructional view showing a conventional hologram recording system;
Fig. 2 is a schematic sectional view showing a hologram recording medium;
Fig. 3 is a schematic constructional view for explaining a hologram recording and reproducing apparatus in the present invention;
Fig. 4 is a schematic plan view for explaining a hologram recording and reproducing apparatus of an embodiment of the present invention;
Fig. 5 is a schematic side view seen from an arrow A of Fig. 4;
Fig. 6 is a schematic side view seen from an arrow B of Fig. 4;
Fig. 7 is a schematic view for explaining a recording stroke in the recording and reproducing apparatus in the present invention;
Fig. 8 is a schematic perspective view showing the hologram recording medium of an embodiment of the present invention;
Fig. 9 is a schematic perspective view showing the area of a diffractive index grating of the hologram recording medium of the embodiment of the present invention;
Fig. 10 is a schematic view for explaining the recording process in the hologram recording and reproducing apparatus in the present invention;
Fig. 11 is a schematic view for explaining a reproducing process in the hologram recording and reproducing apparatus in the present invention;
Fig. 12 is a schematic plan view for explaining the hologram recording and reproducing apparatus of another embodiment of the present invention; and
Fig. 13 is a schematic plan view for explaining the hologram recording medium of another embodiment mode of the present invention.

### DETAILED DESCRIPTION OF THE EMBODIMENTS

The embodiments of the present invention will next be explained in detail with reference to the accompanying drawings.

A reproducing method using a phase conjugate wave is considered as one of methods for making a hologram memory system compact. Phase conjugate reference light (hereinafter called reproducing reference light) with respect to reference light (hereinafter called recording reference light) at a recording time is used to realize this reproducing method using the phase conjugate wave. Namely, the phase conjugate wave reproducing method at the recording time is the same as the conventional case. However, in this reproducing method, in the reproducing time, the phase conjugate light of signal light is generated in an incident direction of the signal light by using the phase conjugate reproducing reference light having a symmetrical property opposed to that of the reference light at the recording time so that a Fourier transformation lens can be also used as a reverse Fourier transformation lens. Further, even when the phase of a wave front of the phase conjugate light is disturbed by passing this phase conjugate light through the recording medium and the lens, there is a nature of the phase conjugate light in which the phase disturbance is compensated and returned to its original state when the phase conjugate light again reversely passes through the recording medium and the lens. Accordingly, the recording and reproducing apparatus can be made of a simple lens without requiring any high performance in the lens by this nature. Therefore, the recording and reproducing method is very effective to make the recording and reproducing apparatus compact.

Thus, in the phase conjugate reproduction method, it is necessary to set the recording reference light and the reproducing reference light to have the symmetrical properties. Therefore, symmetrically opposed plane waves are generally used. However, since the plane wave is formed even in the vicinity of a converging point of the converged reference light, the symmetrical property is realized by perpendicularly reflecting the plane wave on a plane mirror. In this embodiment, the density of light power is increased and a high speed recording operation is achieved even in a small light amount by converging the recording light (recording reference light and signal light) to a very small area. The reference light is perpendicularly incident to a main face of the recording medium, and the plane mirror is arranged in a beam waist of the reference light, and the reference light is perpendicularly reflected on the plane mirror. The signal light is incident to the recording medium at an acute angle with respect to the reference light. Gate light is coaxial with respect to the reference light and is beam-shaped by a converging method similar to that of the reference light, and is incident to the recording medium.

When light has a certain degree of diameter, it is possible to form a cylindrical sector in which the influence of a diffraction phenomenon is small and there is almost no change in diameter of light even when the reference light is produced by limiting one portion of parallel light by a lens and a diaphragm. It is possible to have the wave fronts of the reproducing reference light and the recording reference light conform to each other by perpendicularly reflecting this reference light on the plane mirror in an arbitrary position so that the reflected light travels in the direction opposite to the incoming reference light. However, in the case of performing the recording to a very small (about several ten µm) area, it is not possible to form a very small cylindrical sector by limitting the beam using a diaphragm (pin hole), due to the diffraction phenomenon. Therefore, this embodiment uses a sector having an approximately cylindrical shape produced by a reference light approximately in the form of a plane wave that is gently converged by means of a lens having a long focal length, or a recording sector having a truncated conical shape produced by a reference light of a spherical wave. In this case, the plane mirror is arranged in the position of the beam waist of the recording reference light and the recording reference light is reflected and directed to an opposite direction to obtain the reproducing reference light by utilizing the reflection of the recording reference light. Thus, the reproducing reference light similar to the recording reference light is obtained so that the wave fronts of both the lights can be made conform to each other.

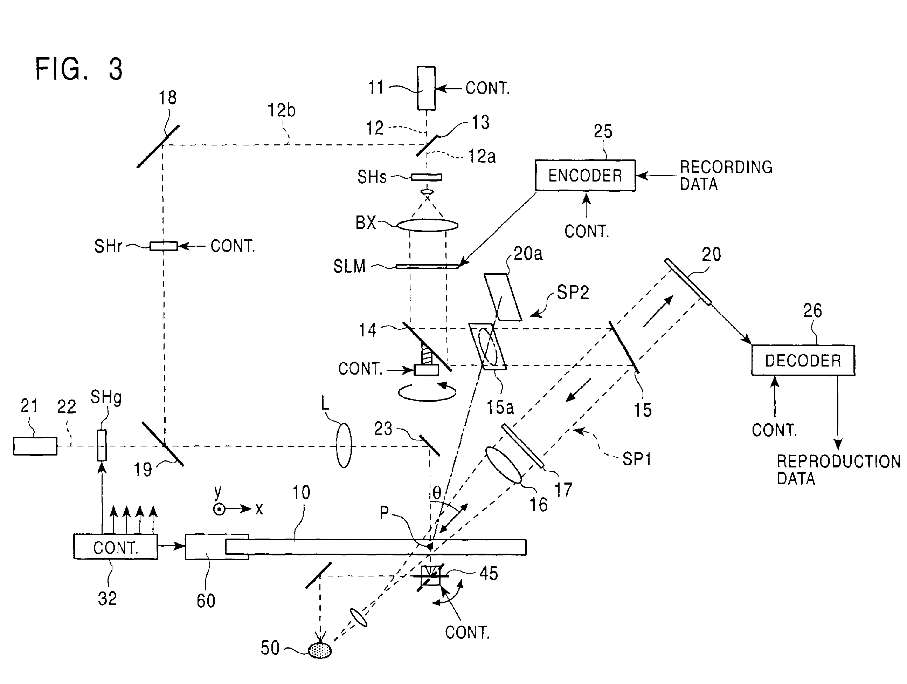

As shown in Fig. 3, a DBR (Distributed Bragg Reflector) laser of a long first wavelength, e.g., 850 nm is used as a near infrared laser beam source in a laser beam source 11 for generating the signal light and the reference light. A laser beam 12 emitted from the laser beam source 11 is divided into signal light beam 12a and recording reference light beam 12b by a beam splitter 13. A shutter SHs, a beam expander BX, a spatial light modulator SLM and a rotating mirror 14 are arranged on an optical path of the signal light beam 12a. Further, a half mirror 15, a phase modulating plate 17 and a Fourier transformation lens 16 are arranged on a straight line as a first signal light path SP1 downstream from the rotating mirror 14.

On the other hand, a mirror 18, a shutter SHr and a dichroic mirror 19 are arranged on an optical path of the recording reference light beam 12b divided by the beam splitter 13. In recording, the signal light beam 12a and the recording reference light beam 12b are irradiated to a crossing position P within the recording medium 10 of a shape of parallel flat plates supported by a movable stage 60 along the different optical paths. Namely, when the shutters SHs, SHr are opened, a beam of the signal light beam 12a supplied to the half mirror 15 of the first signal light path SP1 by the rotating mirror 14 is slantingly irradiated to a main face of the recording medium at a predetermined incident angle θ, and a beam of the recording reference light beam 12b is approximately perpendicularly irradiated to the main face of the recording medium by a perpendicular incident mirror 23 through the dichroic mirror 19 and a convergent lens L. Thus, these beams interfere with each other within the recording medium 10.

For example, when a lithium niobate having a composition close to a constant ratio composition obtained by adding 100 ppm of terbium (Tb) and 5 ppm of iron (Fe) is used as the recording medium 10, the recording medium 10 has no sensitivity to near infrared light without any action on the lithium niobate. Therefore, the recording sensitivity is revealed by simultaneously irradiating gate light to the recording medium 10. The recording sensitivity is revealed only in the recording medium in a passing portion of the gate light within a crossing portion of the signal light and the reference light. Accordingly, when the gate light is converged by the convergent lens and is incident to the recording medium, for example, the hologram of a cylindrical passing portion is recorded. Further, the density of recording light intensity can be raised by diametrically narrowing the recording reference light until a beam diameter equivalent to that of the gate light so that a high speed recording operation can be also performed in the recording medium of low recording sensitivity and the light source of a low output. Thus, the photo refractive material such as LiNbO₃ adding Tb thereto is normally colorless and transparent, but visible light absorption is revealed by irradiating an ultraviolet ray, etc. to this photo refractive material so that an irradiating portion is colored. In this case time, when the visible light is irradiated to the material in the coloring portion, induced absorption (recording sensitivity) is caused in a near infrared area. In contrast, the recording sensitivity with respect to the near infrared light is extremely reduced when the ultraviolet ray is not irradiated to the material. Accordingly, the hologram record is made by using the ultraviolet ray as the gate light and using the near infrared ray as the signal light and the reference light. Therefore,this record mode is called a two-color hologram.

A He-Cd laser of a second wavelength, e.g., 325 nm in wavelength in a band of the ultraviolet ray or the visible light of a short wavelength is used in the light source 21 for generating the gate light. The light source 21 for generating the gate light is a light source having power sufficient to reveal the light induced absorption of the recording medium 10, that is, coloring of the recording medium 10 by the irradiation of light from the light source. When a shutter SHg is opened in the recording process, the gate light 22 emitted from the light source 21 for generating the gate light is reflected on the perpendicular reflecting mirror 23 through the shutter SHg and the convergent lens L, and is irradiated approximately perpendicularly to the main face of the recording medium 10. Accordingly, both the beams of the recording reference light and the gate light are made coaxial and irradiated by the dichroic mirror 19. The convergent lens L converges both the light beams 12b, 22 and irradiates beam spots by reducing the beam diameter so as to form a columnar passing area in the crossing position P within the recording medium 10. The recording medium 10 is arranged in the vicinity of a beam waist of the gate light 22. The shutters SHs, SHr and SHg are arranged to open and close the optical paths of the light beams 12a, 12b and 22. Each of the shutters is opened and closed by a signal sent by a controller 32 through a driver.

As shown in Fig. 3, a rotatable plane mirror 45 is arranged just near the recording medium 10 on an opposite side of the recording medium 10 on the optical path of the recording reference light beam 12b. The plane mirror 45 is used to generate a phase conjugate wave in the reproducing time. In reproducing, the plane mirror 45 is fixed such that the plane mirror 45 is opposed to the recording reference light beam 12b passing through the recording medium 10, i.e., the recording reference light beam 12b is perpendicularly incident to the plane mirror 45. Accordingly, phase conjugate reproduction is performed from the recorded hologram by arranging the plane mirror 45 in a position of the beam waist of the recording reference light beam 12b. When the recording reference light beam 12b is irradiated in the reproducing time, the recording reference light beam 12b passes through the recording medium 10 and is regularly reflected on the plane mirror 45 and is changed to reproducing reference light beam 12c. This reproducing reference light beam 12c is again incident to the recording medium 10 so that diffracted light (phase conjugate light as the reproducing light) is obtained by the recording medium 10. In contrast to this, at the recording time, the plane mirror 45 is rotated by control of the controller 32 to prevent stray light and is fixed such that the recording reference light beam 12b is guided to a light absorber 50 such as a charcoal plate close to e.g., a perfect black body. The light transmitted through the recording medium is converged by a lens on the optical path of the signal light beam 12a so as to provide a predetermined beam diameter to reduce the stray light of the signal light. Thereafter, the converged light is guided to the light absorber 50 or a light absorber of the same kind arranged separately from the light absorber 50.

The beam expander BX enlarges the beam diameter of the signal light beam 12a passing through the shutter SHs upstream from the first signal light path SP1 of the signal light beam 12a inclined with respect to the recording medium, and changes the signal light beam 12a to parallel light. The beam expander BX then irradiates the parallel light such that this parallel light is perpendicularly incident to the spacial light modulator SLM. The spatial light modulator SLM receives electric data of a unit page series corresponding to a two-dimensional plane page received from an encoder 25, and displays a light and dark dot matrix signal. The signal light beam 12a is optically modulated by passing through the spatial light modulator SLM so that the signal light beam 12a includes the data as a dot matrix component. The modulated beam is sent to the half mirror 15 by the rotating mirror 14 of the first signal light path SP1, and the Fourier transformation lens 16 Fourier-transforms the signal light beam 12a and converges the signal light beam 12a so as to form a focal point in the position P of the recording medium 10 or behind the position P. The half mirror 15 supplies a phase conjugate wave described later to a photo detector 20 such as an image pickup element of a photo detector array, e.g., a CCD. The spatial light modulator SLM and the photo detector 20 are arranged at a focal length of the Fourier transformation lens 16. It is possible to relax the convergence of zeroth-order light to one point using this Fourier transformation lens by arranging the phase modulating plate 17 between the spatial light modulator and the recording medium so that the unbalance of a power ratio with respect to a modulated signal component can be also relaxed.

Further, the photo detector 20 branched from the half mirror 15 on the same line is arranged in the first signal light path SP1 in addition to the half mirror 15, the phase modulating plate 17 and the Fourier transformation lens 16. The half mirror 15 is arranged in a position able to send the phase conjugate wave to the photo detector 20. A decoder 26 is connected to the photo detector 20. The decoder 26 is connected to the controller 32. When a mark corresponding to the kind of a photo refractive crystal is formed on the recording medium 10 in advance and the recording medium 10 is mounted onto the movable stage 60 as a supporting means for moving this recording medium 10, the controller 32 automatically reads this mark by a suitable sensor, and can control the movement of the recording medium.

Further, in the embodiment, a second signal light path SP2 is arranged in addition to the first signal light path SP1. The second signal light path SP2 is constructed by a half mirror 15a, a photo detector 20a, a phase modulating plate 17a described later and a Fourier transformation lens 16a described later.

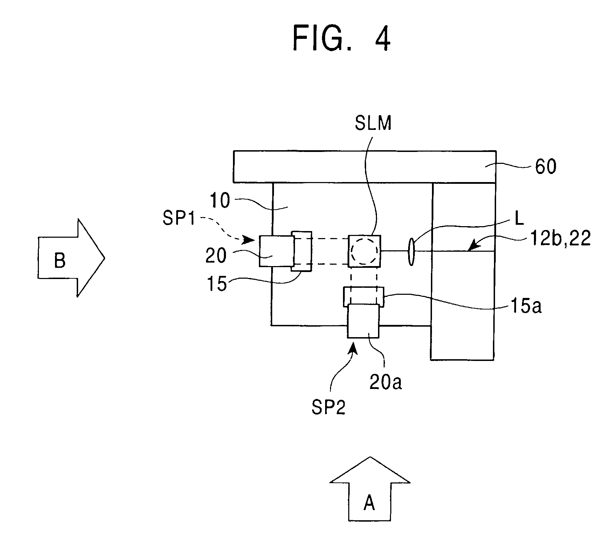

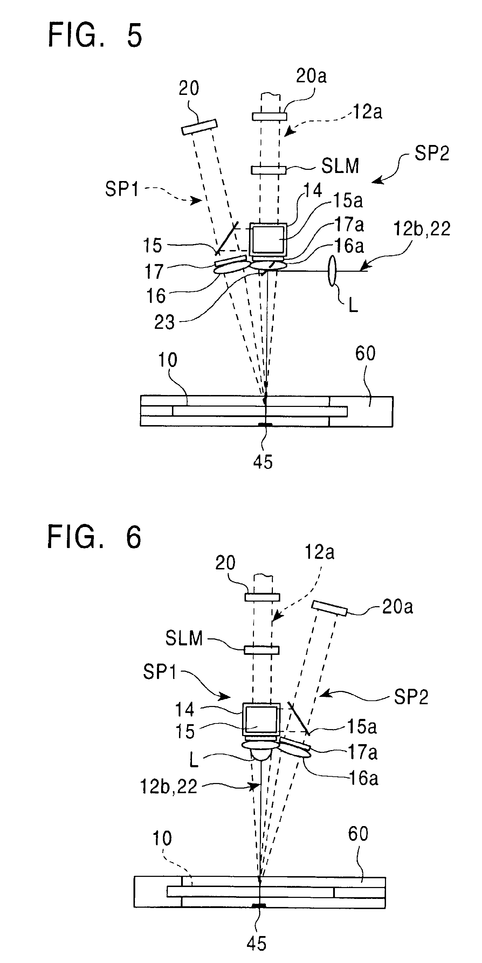

As shown in Figs. 4, 5 and 6, two systems of the first signal light path SP1 and the second signal light path SP2 are arranged above the movable stage 60 supporting the recording medium 10. The signal light is supplied from the rotating mirror 14 to each of these paths. The first and second signal light paths SP1 and SP2 make the signal light incident to the recording medium 10 at an incident angle ⊖, but rotate the plane of incidence e.g., 90 degrees around optical axes of the reference light and the gate light and make the signal light incident from different directions. Thus, for example, the area of a refractive index grating can be recorded or formed in a way that lattice vectors of the refractive index grating in adjacent areas of the diffractive index grating exist in directions different from each other for each area of each refractive index grating.

As shown in Fig. 3, the signal light beam 12a is supplied to the signal light paths of two systems or more by the rotating mirror 14, and switching and recording operations are performed by the controller 32 every recording position such that an angle ⊖ formed between the signal light and each of the reference light and the gate light is constant and incident directions to the recording medium 10 are different from each other.

A two-color hologram recording stroke procedure for recording a hologram by simultaneously irradiating the reference light and the gate light coaxially adjusted with respect to the reference light in synchronization with the signal light at each recording time will be described in detail.

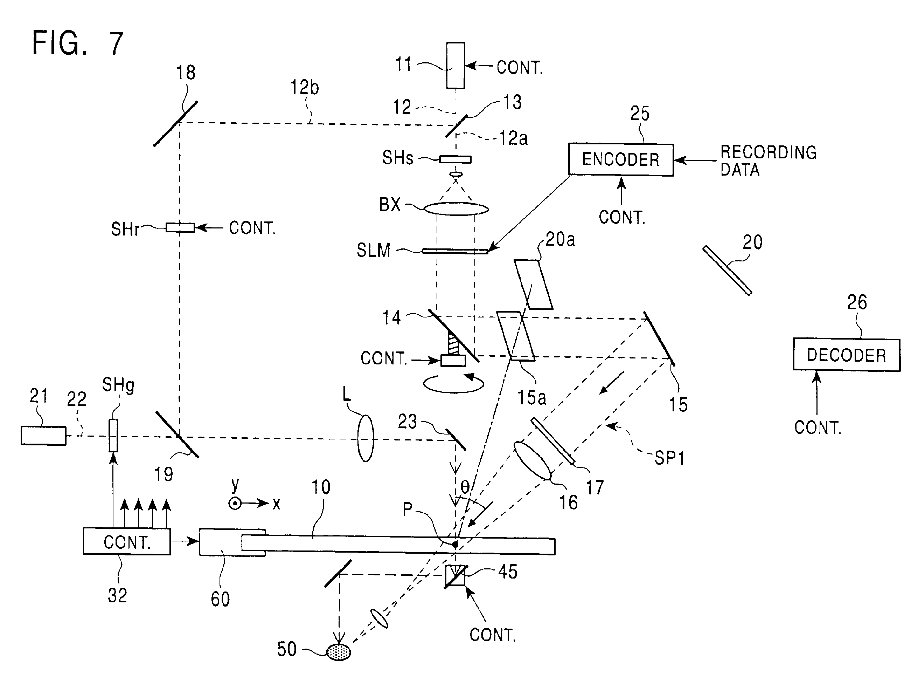

First, as shown in Fig. 7, the plane mirror 45 is rotated to a stray light preventing state and is fixed such that the recording reference light beam 12b and the gate light 22 are not regularly reflected, i.e., are not returned to the recording medium. Next, the recording medium 10 as an object is moved to a predetermined position by controlling the position of an n (n=1 or 2) axis movable stage 60 holding the recording medium 10 by the controller 32. Next, a recording signal is sent from the encoder 25 to the spatial light modulator SLM, and a predetermined pattern is displayed. Next, the shutter SHg is opened and a portion already recorded by preceding irradiation of the gate light is erased and the recording operation is started by opening the shutters SHs, SHr together with the irradiation of the gate light. Next, the recording operation is performed for a predetermined time controlled by the controller 32, i.e., the lights interfere with each other. Next, the shutters SHg, SHr, SHs are closed. Next, the plane mirror 45 is rotated and returned to a regular reflecting state and is fixed. The recording operation is thus completed and a light interference pattern of the reference light and the signal light is formed within the recording medium 10, and the recording medium is partially excited by the gate light so that information is recorded as a change in refractive index. After the recording operation on a first page is terminated, the recording medium 10 is moved by a predetermined amount and the position of the recording reference light beam 12b with respect to the recording medium is changed and the recording operation on a second page is performed by the same procedure. In this case, the supply of the signal light to the first signal light path SP1 is switched to the second signal light path SP2 by control of the rotating mirror 14 using the controller 32, and a sequential record is made.

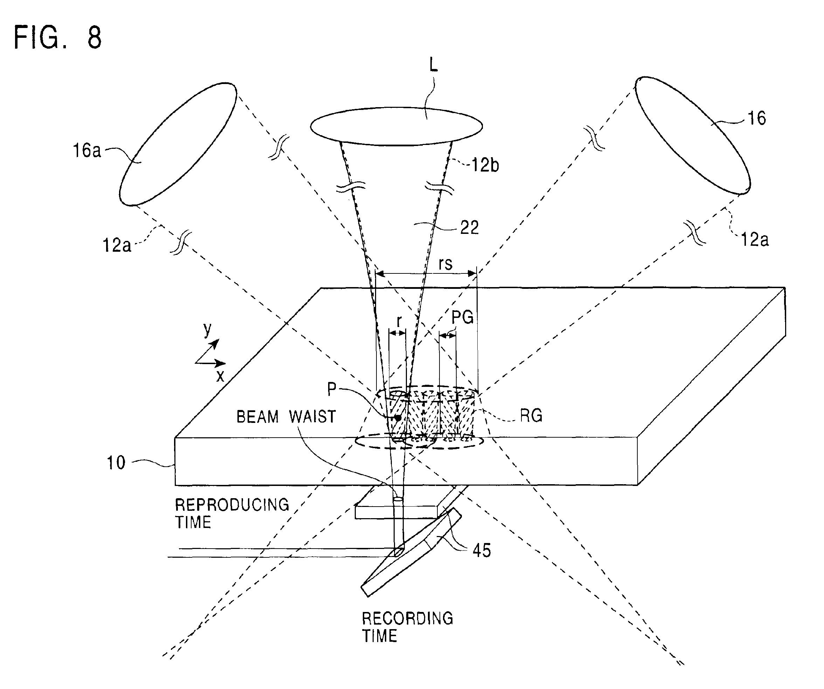

Fig. 8 shows an incident state example of the gate light, the recording reference light and the signal light to the recording medium. Each of areas RG of a refractive index grating approximately having a cylindrical shape is approximately perpendicularly extended to the main face of the hologram recording medium 10. For example, the gate light or the recording reference light and the gate light of a diameter r on the recording medium main face approximately perpendicularly incident, and the signal light of a diameter rs on the same main face are incident such that rs>r is formed as in the case of e.g., r=30 µm and rs=100 µm. Further, it is preferable to have a sufficient length with respect to thickness T of the recording medium 10, e.g., T/r>2 so as to record information approximately in a cylindrical shape.

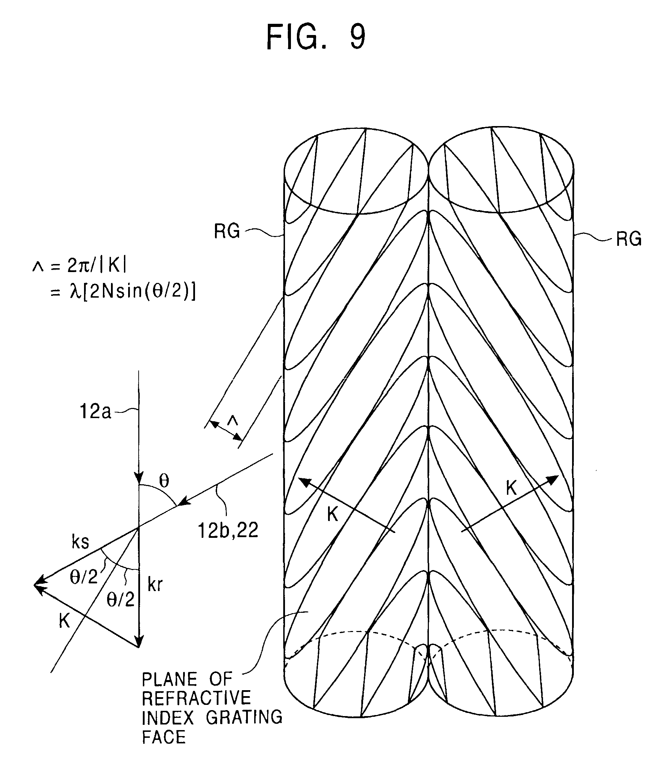

As shown in Fig. 9, a space diffraction grating (a stationary process in time) can be first formed by the recording reference light beam 12b and the signal light beam 12a in an area RG of the refractive index grating. Reflected light of the recording reference light beam 12b from the plane mirror 45 is considered as if this reflected light is transmitted through the recording medium and is converged to phase conjugate light. Accordingly, a transmission type diffraction grating is formed by interference of these lights. Given that a wave number vector of the recording reference light beam 12b is kr, and a wave number vector of the signal light beam 12a is ks, an obtained lattice vector K is represented by K=(kr-ks). In the case of a Pockels effect material (photo refractive material), the population grating of an atomic number distribution relative to upper and lower levels within the recording medium according to light interference distributions of the recording reference light beam 12b and the signal light beam 12a is formed. The diffraction grating, i.e., the diffractive index grating can be formed by causing a change in refractive index proportional to this population grating. A space modulating depth at this time depends on light intensity. Accordingly, the direction in which the plane of refractive index grating, that is an interference fringe, enlarges is a direction in which an angle formed by advancing directions of the recording reference light beam 12b and the signal light beam 12a is equally divided. In this case, it can be regarded that the recording reference light beam 12b is reflected on the recording medium and is converted to phase conjugate light. Accordingly, a reflection type diffraction grating is also formed.

The interval of any diffraction grating is Λ = 2π/|K| =λ[2Nsin(θ/2)]. In this case, θ is an angle of the signal light beam 12a formed within the recording medium with respect to the reference light beam 12b, and N is a refractive index of the recording medium. When θ is very small, the grating interval in the transmission type is wider than that in the reflection type. The lattice vectors of the transmission type and the reflection type are approximately perpendicular to each other. Accordingly, if the contribution of one diffraction grating is superior, contribution of the other diffraction grating is relatively weakened so that practically only one diffraction grating works strongly.

Accordingly, in the present invention, in a photo refractive crystal hologram recording medium of a uniaxial crystal of a shape of parallel flat plates having a plurality of areas of the refractive index grating corresponding to one portion demarcated by the gate light in an interference pattern of the signal light and the recording reference light, each of the areas of the diffractive index grating has a columnar shape and the areas of the diffraction grating are juxtaposed in parallel with each other. The lattice vectors K in the areas RG of the refractive index grating juxtaposed in parallel with each other exist in directions different from each other. This can be confirmed by a phase difference microscope.

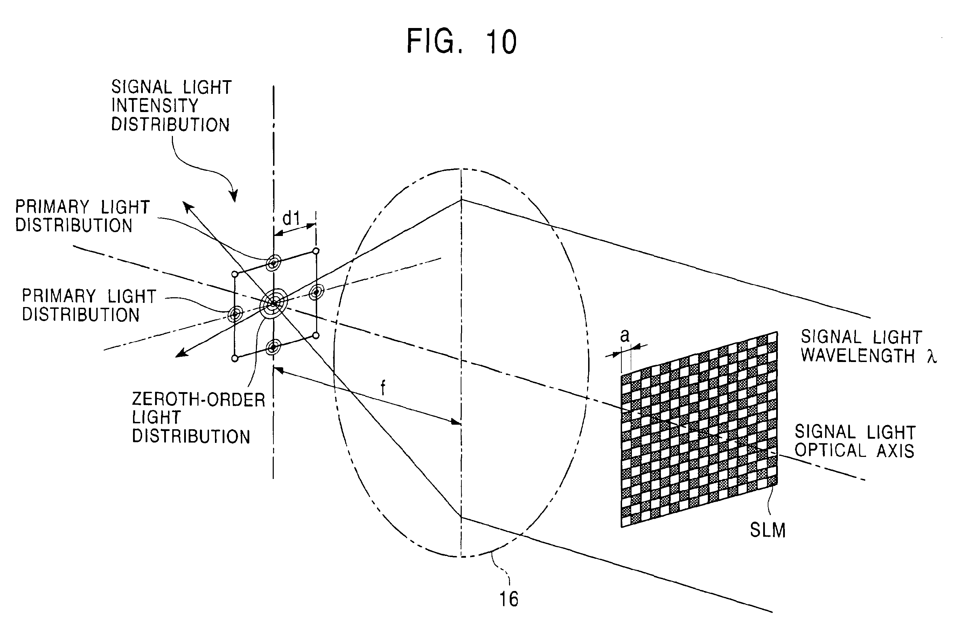

A further considerration will be made for a case in which a refractive index changing area of the recording reference light and the signal light is limited by using the gate light. As shown in Fig. 10, in the signal light Fourier-transformed by the optical space modulator in the hologram record of the Fourier transformation, primary diffracted light caused by repeating pixels (pitch is set to a) of the optical space modulator becomes a maximum frequency component. When the recording operation is performed within the recording medium 10 by the interference of the signal light and the reference light, spatial frequency spectrum distribution light intensity is caused on a Fourier face. The distance (d1) between zeroth-order and primary Fourier spectra on the Fourier face, i.e., the distance between peaks of the zeroth-order and primary diffracted lights can be represented by dl=(1/a) · (λ) · (f) using a spatial frequency (1/a) on a recording face, a light wavelength (λ) and a focal length (f) of the Fourier transformation lens.

For example, when the refractive index of the recording medium is 2 and the thickness of the recording medium is set to 3 mm, and the optical system of an embodiment device is a 1000 x 1000 optical space modulator of a TFT crystal and a pixel pitch a is 10 µm and a signal light wavelength is 530 nm and a focal length is 14 mm, the Fourier spectrum distance (d1) corresponding to this case becomes about 750 µm from the above formula. Accordingly, a large part of information of the signal light exists in a range of about ±750 µm from an optical axis. As shown in Fig. 10, two-dimensional data appearing in the optical space modulator are scattered within the space of a grid type constructed by this primary diffracted light and the zeroth-order light. Therefore, a large part of a fundamental wave component important in the record is concentrated on the periphery of the zeroth-order light. Accordingly, information of a higher harmonic wave component near the primary diffracted light of the pixels becomes relatively less important.

Therefore, in the present invention, the diameter (d2) of the gate light is set to d1>d2 with respect to the Fourier spectrum distance (d1) even when the Fourier spectra of the signal light adjacent to each other in the recording are overlapped with each other. Further, areas limited and recorded by the gate light are set such that these areas are adjacent to each other without overlapping, i.e., a gate light pitch PG is set to PG ≥ d2. Thus, information can be multiplexed and recorded in closest packing by a periodic spatial arrangement.

A beam of the signal light approximately having a zero incident angle to the recording medium and a beam of the recording reference light at an incident angle θ in Fig. 3 generate an interference fringe at an angle of θ/2 with respect to an optical coaxis of these beams. In the photo refractive crystal, recording sensitivity is high in a direction in which the direction of the generated diffraction grating is perpendicular to its optical crystal axis. Accordingly, the recording medium for setting the optical crystal axis extended at an angle of 90-θ/2 with respect to the optical axis is preferable. However, if the signal light and the incident angle θ are reduced, a pickup device can be made compact. Accordingly, in the hologram recording medium, it is also preferable to arrange the optical crystal axis approximately in parallel with its main face.

The optical crystal axis of the recording medium is set to be approximately parallel to a main face direction of its parallel flat plate. At the recording time, the diffraction grating is formed in the direction of a bisector of a forming angle of the recording reference light and the signal light. At this time, recording sensitivity is used at its maximum when the direction of this diffraction grating is perpendicular to the optical crystal axis of the recording medium. The recording sensitivity is reduced in a trigonometric function as the direction of the diffraction grating is shifted from the perpendicular direction. Namely, the diffraction grating formed by the recording reference light and the signal light is close to the direction perpendicular to the optical crystal axis, and the transmission type hologram is easily recorded. However, the diffraction grating (reflection type hologram) constructed by the reference light and the signal light reflected on the plane mirror 45 is close to a direction parallel to the optical axis of the recording medium so that the recording sensitivity is very small and no hologram is easily recorded. In reproduction, the light reflected on the plane mirror 45 acts as reproducing reference light so that diffracted light (reproduction conjugate light) is obtained from the recording medium. The normal hologram is naturally reproduced by the incident light, but has no influence on the phase conjugate reproduction since diffracting directions are different from each other.

A stroke procedure of the two-color hologram reproduction will next be described.

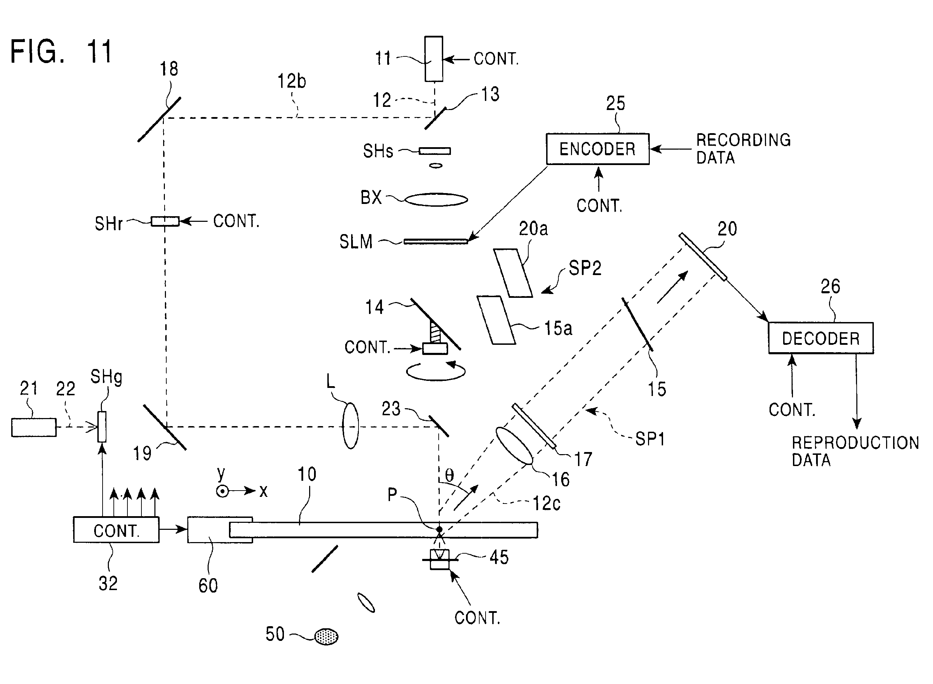

First, as shown in Fig. 11, the position of the n-axis movable stage 60 holding the recording medium 10 is controlled by the controller 32 so that the recording medium 10 as an object is moved to a predetermined position. Next, only the shutter SHr is opened and the reproduction is started. Next, the reproduction is performed for a predetermined time controlled by the controller 32. Next, the shutter SHr is closed. Thus, the reproduction is completed.

As shown in Fig. 8, the plane mirror 45 is arranged such that a reflecting face of the plane mirror 45 is located in a beam waist of the recording reference light beam 12b and a normal line of this reflecting face is conformed to an incident optical path of the recording reference light beam 12b. In the reproduction process, the recording reference light beam 12b passes through the recording medium 10, and is regularly reflected on the plane mirror 45, and is changed to reproducing reference light beam 12c and is again incident to the recording medium 10. Thus, diffracted light (phase conjugate light as reproducing light) is obtained from the recording medium 10, and the phase conjugate reproduction can be achieved from the recorded refractive index grating. This light becomes a divergent spherical wave from a spherical wave converged in the beam waist via a plane wave. Accordingly, if the plane mirror is arranged in parallel with the wave front of this plane wave in the beam waist position, phase conjugate lights having this convergent spherical wave and the divergent spherical wave similar to each other and advancing directions coaxially opposed to each other are obtained.

In reproduction, the normal hologram is also reproduced by the recording reference light beam 12b, but exerts substantially no influence on a reproduction detecting system since the normal hologram is reproduced in an opposite direction not concerned in the reproduction detecting system. Since the plane mirror 45 is arranged so as to be opposed to the recording reference light beam 12b, light obtained by transmitting the recording reference light beam 12b through the recording medium 10 and reflecting the recording reference light beam 12b on the plane mirror 45 is set to reproducing reference light beam 12c. The recording reference light beam 12b and the reproducing reference light beam 12c pass through the same optical path every time. Thus, in a reproducing method using the phase conjugate wave, it is necessary to set the recording reference light beam 12b and the reproducing reference light beam 12c to have symmetric properties. Therefore, symmetrical opposed plane waves or spherical waves are used in both the recording reference light beam 12b and the reproducing reference light beam 12c.

The reproducing reference light beam 12c is coaxial with respect to the recording reference light beam 12b at any time and is propagated in the opposite direction and is incident to the recording medium 10. Thus, diffracted light (phase conjugate wave) is generated from the refractive index grating of a cylindrical shape. The Fourier transformation lens 16 guides this diffracted light to the half mirror 15, and this dot pattern signal is received by a light receiver of the photo detector 20 and is reconverted to an electric digital data signal. Thereafter, when the electric digital data signal is sent to the decoder 26, original data are reproduced. After the reproduction on a first page is terminated, the recording medium 10 is moved by a predetermined amount so that the position of the recording reference light beam 12b with respect to the recording medium is changed and the reproduction on a second page is performed in the same procedure.

In this case, the photo detector 20 is switched to the photo detector 20a and light is received. Cross talk can be reduced since the diffraction grating (refractive index grating) is spatially reproduced mutually independently between adjacent portions in a recording portion of the recording medium.

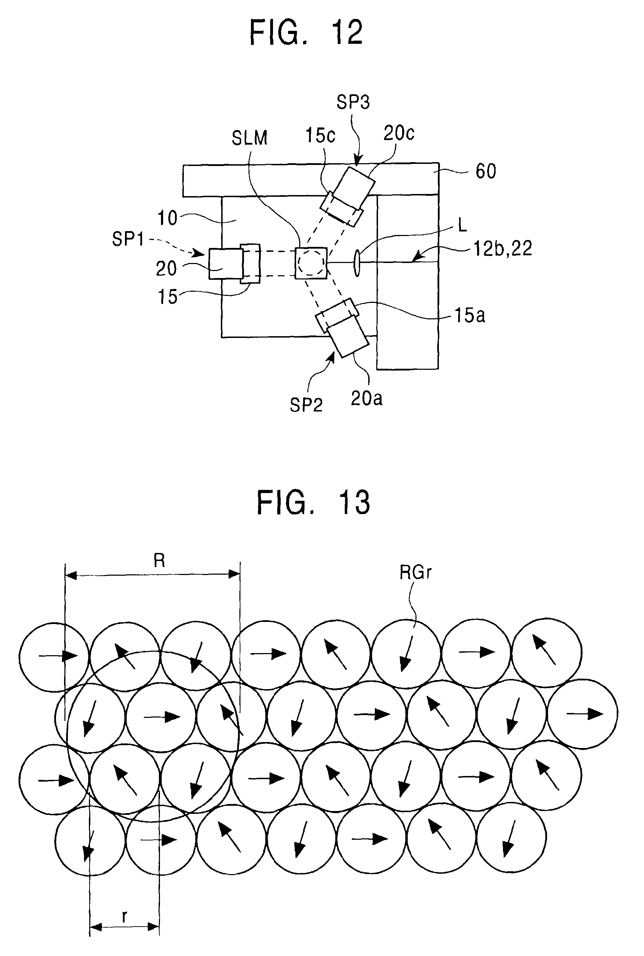

In another embodiment, as shown in Fig. 12, three sets of Fourier transformation lenses having incident faces mutually rotated by 120 degrees around the optical axes of the reference light and the gate light are used by the recording reproduction to the recording medium in the above procedure. Namely, In the case of a first signal light path SP1, a second signal light path SP2 and a third signal light path SP3, when the diameter of an area RG of one refractive index grating of a cylindrical shape is set to r as shown in Fig. 13, a reference light spot diameter at a reading time can be allowed until 2.46r at its maximum. An arrow shown within each area RG of Fig. 13 shows a main face direction component of the lattice vector K.

First, at the reproducing time, when the reference light is incident to the recording portion of the recording medium, the diffracted light according to a recording signal is transmitted through the Fourier transformation lens and the phase modulating plate through which the diffracted light passes as the phase conjugate light at the recording time. The diffracted light is focused and formed as an image by a predetermined photo detector array, and is photoelectrically converted so that a signal is modulated. At this time, the position of the recording medium is controlled by the controller 32 such that the sum of outputs of the photo detectors 20 of the respective signal light paths is observed and only a predetermined desirable photo detector output becomes a maximum value and the other photo detector outputs are minimized. Thus, it is possible to perform servo control for the irradiation of the reference light in the reproducing time.

In the above embodiment, the recording signal light is switched by the rotating mirror 14 commonly using one set of the beam expander BX and the spatial light modulator SLM. However, the hologram recording and reproducing apparatus can be also constructed by a plurality of spatial light modulators such that the beam expander BX and the spatial light modulator SLM are independently arranged in the respective signal light paths, and light branched from the light source by the shutter is supplied to each of the spatial light modulators SLM.

Furthermore, in the above embodiment, the photo detector array is arranged for each signal light path and a plurality of detecting lines are arranged. However, an arrangement using one common photo detector array can be adopted by a construction that allows selection of an incident path to the photo detector array from an area of the refractive index grating as a target of the reading by means of a shutter, and the like.

Furthermore, in the above embodiment, the hologram recording is realized in a transmission type diffraction grating. However, equivalent effects can be also obtaied by using a reflection type diffraction grating. In such a case, the optical axis of the recording medium is approximately perpendicular to the main face, and the recording and reproduction is performed while fixing the plane mirror 45 of Fig. 3 which is rotated to prevent the stray light in recording. Also in this case, in the recording time the diffraction grating is formed in the directions of bisector angles of the recording reference light and the signal light, and the recording sensitivity becomes maximum when this direction is perpendicular to the optical axis of the recording medium. The recording sensitivity reduces in the form of a trigonometric function as this direction is shifted from the perpendicular direction. In other words, the strength of recording and reproduction reference light beams are reduced reversely to the above embodiment, and the diffraction grating constructed by the reference light and the signal light reflected on the plane mirror 45 is close to a direction perpendicular to the optical axis of the recording medium. Therefore, the recording sensitivity is large and the reflection type hologram is formed. However, the diffraction grating (transmission type hologram) constructed by the incident reference and signal lights is close to a direction parallel to the optical axis of the recording medium so that the recording sensitivity is very small and this hologram is not easily recorded. In reproducing, the incident reference light acts as reproducing reference light for the phase conjugate reproduction, and diffracted light (reproducing conjugate light) from the recording medium is obtained. The normal hologram is similarly reproduced by the reflected light, but has no influence on the phase conjugate reproduction since diffracting directions are different from each other.

In this embodiment, since the two-color hologram is recorded by the gate light reduced in diameter, a recording portion formed in the recording medium is formed in a needle elongated shape so that a spatial multiplex record can be efficiently made. Similarly, since the density of recording light intensity is improved by reducing the diameter of the reference light in the recording, a high speed recording operation can be also performed in the recording medium of low recording sensitivity and the light source of a low output.

In the above embodiment, since a gate light irradiating area at the recording time is activated and set to a recording area, the explanation is made with respect to the two-color hologram having no reproduction deterioration and using the gate light constituting a very small sector while the gate light is formed by a converging method similar to that of the recording reference light. However, even when no gate light is irradiated at the recording time, a compact hologram memory system can be achieved if the very small sector is formed by at least the recording reference light in the above converging method and the phase conjugate reproduction is performed in the reproducing time. In this case, scheduling is required since the recording operation is performed while an adjacent recording portion is erased.

Further, in another modified example, if a 1/4 wavelength plate is arranged between the recording medium 10 and the plane mirror 45, the recording reference light beam 12b passes through the 1/4 wavelength plate twice after the recording reference light beam 12b is transmitted through the recording medium 10. Thus, a polarizing direction of the reproducing reference light beam 12c incident to the recording medium 10 can be changed by 90 degrees. Accordingly, a separating optical system for guiding all the signal light to the recording medium 10 and guiding all the diffracted light to a CCD side can be constructed by using a polarizing beam splitter in an optical system for separating the signal light beam 12a from the spatial light modulator SLM and the diffracted light (phase conjugate light as reproducing light) transmitted to the photo detector 20. Thus, light amount can be effectively used.

In the present invention, the signal light beam and the recording reference light beam cross each other within the recording medium, and the gate light beam for revealing recording sensitivity of the recording medium is simultaneously irradiated to the recording medium so as to pass through a portion of the recording medium in which the signal light beam and the recording reference light beam cross each other and demarcate a volume smaller than that of this crossing portion. Accordingly, a recording area is formed in an elongated, needle-like shape so that a spatial multiplex record can be efficiently made. Furthermore, in accordance with the present invention, a reproduction image from the area of the refractive index grating of the recording medium is formed in a position spatially independent of a reproduction image from the area of an adjacent refractive index grating. Accordingly, it is possible to reduce cross talk from the area of the adjacent refractive index grating in the reproducing time. Furthermore, the area of the refractive index grating can be formed by generating a modulation signal or modulation signals by using one or a plurality of spatial light modulators in the recording time, and controlling the direction of the modulation signal incident into the recording medium. A closest packing-type recording can be achieved by employing three or more kinds of directions of incident, of the signal light. Furthermore, the spatially independent reproduction image can be detected by arranging one or a plurality of photo detecting arrays in the reproduction time. In accordance with the present invention, even when no large-sized light source is used, a recording time is shortened by increasing light power density by converging the recording light (recording reference light and signal light) to a very small area, and a high speed record and an increase in recording density can be achieved by effectively utilizing recordable capacity of the recording medium by overlapping columnar recording areas. Further, phase conjugate reproduction in which wave fronts of the recording reference light beam and signal light beams are conformed to each other can be realized by an arrangment that reflection occurs in the beam waist of the recording and reproduction light beams. Accordingly, a recording and reproducing optical system is simplified so that a memory system can be made compact.

In the present invention, since no multiplex operation is performed in the same sector, the change in refractive index of the recording medium due to the recording is hardly added and the difference in wave front between transmission light of the recording medium and incident light is made small even when the transmission light of the recording medium is used as reference light. This is quite advantageous in the signal reproduction. Furthermore, it is possible to avoid the overlapping of influences due to the formation of diffraction grating in a direction in which the recording sensitivity is small in the recording medium. Therefore, influences on the reproduction can be kept small even when no measure is taken to shield the reflected light.

## Claims

1. A hologram recording medium made of a photo refractive crystal of a uniaxial crystal having a shape of parallel flat plates, and having a plurality of areas of a refractive index grating corresponding to one portion of a three-dimensional light interference pattern of a coherent signal light beam and coherent reference light of a first wavelength modulated in accordance with information data, wherein the areas of said refractive index grating respectively have a spatially independent columnar shape and are juxtaposed in parallel with each other, and lattice vectors of said refractive index grating in the adjacent areas of said refractive index grating exist in directions different from each other.

2. A hologram recording medium according to claim 1,
wherein the photo refractive crystal is a crystal increased in recording sensitivity at said first wavelength when a gate light beam of a second wavelength is simultaneously irradiated in addition to the reference light and the signal light of said first wavelength, and/or
wherein the photo refractive crystal has an optical crystal axis approximately parallel or perpendicular to a main face of the recording medium, and/or
wherein information data of one screen are stored for each area of said refractive index grating, and/or
wherein each of the areas of said refractive index grating of the columnar shape is extended approximately perpendicularly to the main face of the hologram recording medium, and/or
wherein each of the areas of said refractive index grating of the columnar shape approximately has a cylindrical shape, and/or
wherein a maximum inside diameter of the areas of said refractive index grating is smaller than the distance between peaks of zeroth-order and primary diffracted lights of a light intensity distribution of said signal light beam.

3. A hologram recording method for forming a plurality of areas of a refractive index grating corresponding to one portion of a three-dimensional light interference pattern of a coherent signal light beam and coherent reference light of a first wavelength modulated in accordance with information data within a recording medium made of a photo refractive crystal of a uniaxial crystal having a shape of parallel flat plates,
wherein said signal light beam and the recording reference light beam cross each other within said recording medium, and a gate light beam having a second wavelength for revealing recording sensitivity of said recording medium is simultaneously irradiated to said recording medium so as to pass through a portion of the recording medium for crossing said signal light beam and the recording reference light beam and demarcate a volume smaller than that of this crossing portion, and
said signal light beam is irradiated to said gate light beam from a different direction such that lattice vectors of said refractive index grating in adjacent areas of said refractive index grating exist in directions different from each other for each area of said refractive index grating.

4. A hologram recording method according to claim 3,
wherein said gate light beam is converged and said recording medium is arranged in a waist of this gate light beam and its vicinity, and the areas of said refractive index grating are formed in a columnar shape and are juxtaposed in parallel with each other, and/or
wherein said recording medium has an optical crystal axis approximately parallel or perpendicular to a main face of the recording medium, and/or
wherein said recording reference light beam and said gate light beam are coaxially irradiated, and/or
wherein said recording reference light beam is converged, and/or
wherein said recording reference light beam and said gate light beam are approximately perpendicularly irradiated to a main face of said recording medium, and the areas of said refractive index grating of a columnar shape are approximately perpendicularly extended to the main face of said recording medium, and/or
wherein the gate light beam and the signal light beam are respectively irradiated such that a cross sectional area of said gate light beam on the surface of said recording medium is smaller than that of said signal light beam, and/or
wherein a maximum inside diameter of the areas of said refractive index grating is smaller than the distance between peaks of zeroth-order and primary diffracted lights of a light intensity distribution of said signal light beam.

5. A hologram reproducing method for reproducing information data from a hologram recording medium in which the hologram recording medium is made of a photo refractive crystal of a uniaxial crystal having a shape of parallel flat plates, and has a plurality of areas of a refractive index grating respectively corresponding to one portion of a three-dimensional light interference pattern of a coherent signal light beam and coherent reference light modulated in accordance with the information data, and respectively having a spatially independent columnar shape, and juxtaposed in parallel with each other, and lattice vectors of said refractive index grating in the respective adjacent areas of said refractive index grating exist in directions different from each other, wherein the coherent reference light is incident to each of the areas of said refractive index grating of said hologram recording medium at a predetermined incident angle, and an image is formed in a spatially independent different direction from at least the adjacent areas of said refractive index grating.

6. A hologram reproducing method according to claim 5,
wherein the position of a detecting part for receiving the image formed spatially independently in the different direction from the adjacent areas of said refractive index grating is switched when said reference light beam is incident to each of the areas of said refractive index grating at the predetermined incident angle.

7. A hologram recording and reproducing apparatus for forming a plurality of areas of a refractive index grating corresponding to one portion of a three-dimensional light interference pattern of a coherent signal light beam and coherent reference light of a first wavelength modulated in accordance with information data within a recording medium made of a photo refractive crystal of a uniaxial crystal having a shape of parallel flat plates,
said hologram recording and reproducing apparatus comprising:
a supporting part for detachably holding the recording medium made of the photo refractive crystal having the shape of parallel flat plates;
a reference light part for making a coherent recording reference light beam of the first wavelength approximately perpendicularly incident to a main face of said recording medium;
a signal light part for making the coherent signal light beam of the first wavelength modulated in accordance with the information data of one screen incident to said recording medium, and making the coherent signal light beam cross said recording reference light beam within the recording medium, and generating a light interference pattern of said signal light beam and the recording reference light beam;
a gate light part for making a gate light beam of a second wavelength for revealing recording sensitivity of said recording medium approximately perpendicularly incident to the main face of said recording medium together with said recording reference light beam, and forming the refractive index grating of one portion of said light interference pattern which passes through a portion of said recording medium for crossing said signal light beam and the recording reference light beam and demarcates a volume smaller than that of this crossing portion;
a switching part for irradiating said signal light beam to said gate light beam in a portion of said recording medium from a different direction such that lattice vectors of said refractive index grating in adjacent areas of said refractive index grating exist in directions different from each other for each area of said refractive index grating;
a phase conjugate wave generating part for generating a phase conjugate wave with respect to said signal light beam by irradiating a reproducing reference light beam coaxial with respect to said recording reference light beam and propagated in an opposite direction to said refractive index grating of said recording medium;
a separating part for separating said phase conjugate wave from an optical path of said signal light beam; and
a detecting part for detecting the information data formed as an image by said phase conjugate wave.

8. A hologram recording and reproducing apparatus according to claim 7,
wherein the hologram recording and reproducing apparatus further comprises a part for switching between positions of said detecting part for receiving images formed spatially independently in different directions from the adjacent areas of said refractive index grating when said reference light beam is incident to each of the areas of said refractive index grating at a predetermined incident angle, and/or
wherein said detecting part has a plurality of photo detector arrays, and the reproduction is performed by switching between a plurality of convergent lenses having different incident directions to the recording medium, and/or
wherein said signal light part has a plurality of optical modulators, and the record is made by switching between a plurality of convergent lenses having different incident directions to the recording medium, and/or
wherein the hologram recording and reproducing apparatus further comprises a part for converging said gate light beam and said recording medium is arranged in a waist of said gate light beam and its vicinity, and the areas of said refractive index grating are formed in a columnar shape and are juxtaposed in parallel with each other, and/or
wherein the hologram recording and reproducing apparatus further comprises a part for coaxially irradiating said recording reference light beam and said gate light beam, and/or
wherein the hologram recording and reproducing apparatus further comprises a part for converging said recording reference light beam, and/or
wherein said recording reference light beam and said gate light beam are approximately perpendicularly irradiated to the main face of said recording medium, and the areas of said refractive index grating of a columnar shape are approximately perpendicularly extended to the main face of said recording medium, and/or
wherein the gate light beam and the signal light beam are respectively irradiated such that a cross sectional area of said gate light beam on the surface of said recording medium is smaller than that of said signal light beam, and/or
wherein a maximum inside diameter of the areas of said refractive index grating is smaller than the distance between peaks of zeroth-order and primary diffracted lights of a light intensity distribution of said signal light beam.
